# EUROPEAN PATENT SPECIFICATION

(11) **EP 2 308 114 B1**
(45) Date of publication and mention of the grant of the patent: **20.06.2012**
(21) Application number: 09798177.3
(22) Date of filing: 17.07.2009
(51) Int. Cl.: H01L 51/00, H01G 9/20, H01L 51/42

(54) **REVERSED DYE-SENSITIZED PHOTOVOLTAIC CELL**
UMGEKEHRTES FARBSTOFFSENSIBILISIERTES PV-MODUL
CELLULE PHOTOVOLTAIQUE SENSIBILISEE PAR COLORANT INVERSEE

(30) Priority: 17.07.2008 NL 2001815
(43) Date of publication of application: 13.04.2011
(73) Proprietor: Stichting Energieonderzoek Centrum Nederland, 1755 LE Petten (NL)
(72) Inventor: PEX, Petrus Paulus Antonius Catharina, NL-1755 LE Petten (NL); SOMMELING, Paul Matthieu, NL-2316 XV Leiden (NL)
(74) Representative: van Westenbrugge, Andries
(86) International application number: PCT/NL2009/050446
(87) International publication number: WO 2010/008294

(56) References cited:
- WO-A-99/66520
- US-A1- 2006 062 902
- JUN ET AL: "A study of stainless steel-based dye-sensitized solar cells and modules" SOLAR ENERGY MATERIALS AND SOLAR CELLS, ELSEVIER SCIENCE PUBLISHERS, AMSTERDAM, NL, vol. 91, no. 9, 13 April 2007 (2007-04-13), pages 779-784, XP022027694 ISSN: 0927-0248
- GAZOTTI W A ET AL: "FLEXIBLE POTOELECTROCHEMICAL DEVICES BASED ON CONDUCTING POLYMERS" SYNTHETIC METALS, ELSEVIER SEQUOIA, LAUSANNE, CH, vol. 108, no. 2, 17 January 2000 (2000-01-17), pages 151-157, XP001020876 ISSN: 0379-6779
- ITO S ET AL: "High-efficiency (7.2%) flexible dye-sensitized solar cells with Ti-metal substrate for nanocrystalline-TiO2 photoanode" CHEMICAL COMMUNICATIONS - CHEMCOM, ROYAL SOCIETY OF CHEMISTRY, GB, 14 August 2006 (2006-08-14), pages 4004-4006, XP002507808 ISSN: 1359-7345 [retrieved on 2006-08-14]

## Description

### Field of the invention

The invention relates to a photovoltaic element comprising a layered structure of at least a first electrically conductive layer, a layer of crystalline metal oxide semiconductor material deposited on the first electrically conductive layer, a transparent second electrically conductive layer deposited on a transparent substrate and an hole conducting medium contained between the layer of semiconductor material and the second electrically conductive layer.

### Background of the invention

Such an element is known from the American patent no. 4,927,721. This patent discloses a photo-electrochemical cell comprising a polycrystalline metal oxide semiconductor layer having a substantially monomolecular chromophore layer in a surface zone. The metal oxide semiconductor layer is a TiO₂-layer having a roughness factor of preferably more than 200, deposited on a Ti-substrate. The TiO₂-layer is obtained by a process which is repeated several times, according to which a titanium-ethoxide solution in methanol is applied to the titanium substrate, after which the resulting titanium alkoxide is hydrolyzed and heated.

Known from the American patent no. 5,350,644 is a photovoltaic cell, which comprises a light-transmitting electrically conductive layer which is deposited on a glass plate or a transparent polymer foil to which a number of preferably porous layers of titanium dioxide have been applied and wherein at least the last titanium dioxide layer is doped with a divalent or trivalent metal ion. The combination of titanium dioxide and conductive layer forms the photo electrode of a solar cell, which solar cell further comprises a light-transmitting second electrically conductive layer which is deposited on a light-transmitting substrate and which forms a counter-electrode. Received between photo electrode and counter-electrode is an electrolyte acting as redox system.

The operation of known solar cells, such as for instance described in American patent no. 4,927,721, is as follows. A photon from the visible light incident via the photo-electrode or counter-electrode releases an electron at the interface of titanium dioxide and electrolyte from an electron-hole combination, which electron disappears in the conduction band of the titanium dioxide and is discharged via the electrically conductive layer of the photo electrode. The resulting hole is supplemented with an electron from the electrolyte, while the electrolyte accepts an electron from the counter electrode. The acceptance of electrons by the electrolyte can be enhanced by a catalyst applied to the surface of the counter-electrode, while the efficiency of the solar cell can be increased by a sensitizer dye on the surface of the titanium dioxide layer, which dye absorbs light and herein acquires an energy-rich state and is able to inject an electron with an efficiency of almost 100% into the conduction band of the titanium dioxide.

WO 99/66520 describes a photovoltaic element comprising a layered structure of at least a first electrically conductive layer, a layer of crystalline metal oxide semiconductor material deposited on the first electrically conductive layer, a transparent second electrically conductive layer deposited on a transparent substrate and an electrolytic liquid contained between the layer of semiconductor material and the second electrically conductive layer, wherein the layer of semiconductor material is deposited on a metal foil, which metal foil forms the first electrically conductive layer.

Yongseok Jun et al. describes in Solar Energy Materials & Solar Cells 91 (2007) 779-784, a steel-based dye-sensitized solar cell.

Seigo Ito et al. describes in Chem. Commun. 2006 4004-4006 a high-efficiency flexible dye-sensitized solar cell with Ti-metal substrate for nanocrystalline TiO₂ photo anode.

W.A. Gazotti et al describes in Synthetic metals 108 (2000) 151-157 a flexible photo electrochemical device based on conducting polymers.

US2006/0062902 describes CIGS (Cu, In, Ga, Se/S) absorber layers fabricated using coated semiconducting nanoparticles and/or quantum dots. Core nanoparticles and/or quantum dots containing one or more elements from group IB and/or IIIA and/or VIA may be coated with one or more layers containing elements group IB, IIIA or VIA. Using nanoparticles with a defined surface area, a layer thickness could be tuned to give the proper stoichiometric ratio, and/or crystal phase, and/or size, and/or shape. The coated nanoparticles could then be placed in a dispersant for use as an ink, paste, or paint. By appropriate coating of the core nanoparticles, the resulting coated nanoparticles can have the desired elements intermixed within the size scale of the nanoparticle, while the phase can be controlled by tuning the stochiometry, and the stoichiometry of the coated nanoparticle may be tuned by controlling the thickness of the coating(s).

M. Toivola, et al describes in Solar Energy Materials & Solar Cells 90 (2006) 2881-2893 a DSSC built on flexible steel substrates with a corrosion protection coating made of zinc.

### Summary of the invention

Such a known solar cell has a number of disadvantageous properties which stand in the way of large-scale application of this cell. Inherent in the use of glass as transparent substrate material is a determined thickness and stiffness of a solar cell which makes the cell unsuitable for use, for instance in particular products in the field of consumer electronics, such as watches. It is known that replacing glass with a transparent flexible plastic may result in a loss of efficiency of the solar cell.

It is especially an object of the invention to provide a solar cell of very small thickness which has a high efficiency when transparent polymer foil is used and which can be assembled in large quantities in a simple manner.

It is further an objective to provide an alternative solar cell (herein also indicated as "photovoltaic cell" or "PV" cell or "photovoltaic element"), which preferably does not suffer from above-mentioned disadvantages and/or preferably provides the above described desired properties.

This objective may be achieved and other advantages may be gained with a photovoltaic element, such as of the type stated in the preamble, wherein according to the invention the layer of semiconductor material is deposited on a flexible conductive composite foil, which flexible conductive composite foil provides the first electrically conductive layer.

In the solar cell according to the invention light impinges upon the semiconductor material via the transparent counter-electrode and the electrolytic liquid (or other hole conducting medium) between the counter-electrode and the semiconductor material.

The most obvious manner of light incidence in the known cell, i.e. via the photo electrode, is precluded by use of the non-transparent flexible conductive composite foil. A photovoltaic element according to the invention is a "reversed solar cell".

Surprisingly, it has now been found that the efficiency of a reversed solar cell according to the invention may be higher than in a known, above described solar cell (with both electrodes comprising plastic material), wherein the photo electrode is impinged upon directly, and not via the electrolytic liquid (or other hole conducting medium), by the photons of incident sunlight. A cause of the recorded increase in efficiency is sought in the fact that application of a flexible conductive composite foil as substrate material enables sintering of the layer of semiconductor material at higher temperatures than in a known solar cell with a substrate of polymer material.

Further, the flexible conductive composite foil may be relatively easy to make, and/or simple to process and/or may have relatively high mechanical strength, relative to other foils, such as a pure titanium (Ti), tin (Sn) or zinc (Zn) foil. A further advantage may be that the electrically conductive layer is substantially protected from the environment by the support material layer foil. Yet another advantage is that as support material layer foil material abundantly available materials (such as in the form of commercially available foils) may be applied.

Therefore, the invention especially provides a photovoltaic element (or solar cell), comprising a layered structure, as described in claim 1.

Such layered structure or stack as solar cell may be flexible, efficient and stable.

In a preferred embodiment, the flexible conductive composite foil may comprise a laminate comprising a support material layer foil and the first electrically conductive layer. Herein, a support material layer in the form of a foil is indicated as "support material layer foil".

In general, the support material layer foil may be selected from the group consisting of iron foil, iron alloy foils, steel foils (including for instance foils of carbon steel, stainless steel, HSLA steel (high strength low alloy), or tool steel), aluminium foil, copper alloy foils, brass (CuZn) foils, resistance foils (CuNi), nickel foils, silver foils, nickel silver foils, iron nickel foils (such as invar), and the first electrically conductive layer may comprise a layer selected from the group consisting of a titanium layer, a tin layer and a zinc layer.

In an embodiment, the support material layer foil comprises an iron foil or an iron alloy foil and the first electrically conductive layer comprises a titanium layer. In another embodiment, the support material layer foil comprises an iron foil or an iron alloy foil, and the first electrically conductive layer comprises a tin layer. In another embodiment, the support material layer foil comprises an iron foil or an iron alloy foil, and the first electrically conductive layer comprises a zinc layer. Especially, the foil comprises an iron alloy foil, such as a steel foil. In another embodiment, the support material layer foil comprises an aluminium foil and the first electrically conductive layer comprises a titanium layer. In another embodiment, the support material layer foil comprises an aluminium foil and the first electrically conductive layer comprises a zinc layer. In yet another embodiment, the support material layer foil comprises an aluminium foil and the first electrically conductive layer comprises a tin layer.

Such laminate comprising a support material layer foil and the first electrically conductive layer may for instance be obtained by providing a support material layer foil and depositing thereon the first electrically conductive layer. Deposition may in an embodiment be electrochemical deposition, may be spray pyrolysis or chemical vapour deposition (optionally followed by calcination to provide the oxide skin). In another embodiment, deposition may comprise sputtering. Other techniques known in the art may also be applied. An advantage of the laminate comprising a support material layer foil and the first electrically conductive layer is that the first electrically conductive layer may be very thin, such as in the range of about one atomic layer (about 0.1 nm) up to about 100 nm. However, the layer thickness of the first electrically conductive layer may also be up to about a 1 µm. Especially, the first electrically conductive layer and the oxide layer together have a layer thickness in the range of about 20-100 nm. However, the layer thickness of the first electrically conductive layer and the oxide layer together may also be up to about 2 µm.

In a specific embodiment, the laminate comprising a support material layer foil and the first electrically conductive layer is obtainable by providing a first metal doped second metal layer foil, wherein the first metal comprises one or more metals selected from the group consisting of titanium, zinc and tin, and wherein the second metal layer foil comprises a metal layer foil, especially selected from the group consisting of iron foil, iron alloy foils, steel foils (including for instance foils of carbon steel, stainless steel, HSLA steel (high strength low alloy), or tool steel), aluminium foil, copper alloy foils, brass (CuZn) foils, resistance foils (CuNi), nickel foils, silver foils, nickel silver foils, iron nickel foils (such as invar), and providing a heat treatment to the first metal doped second metal layer foil. Because of the heat treatment, the first metal may migrate to the surface of the second metal layer foil, and may form the first electrically conductive layer on the second metal layer foil, thereby providing in an embodiment the laminate comprising a support material layer foil and the first electrically conductive layer.

In yet another embodiment, the laminate comprising a support material layer foil and the first electrically conductive layer comprises a laminate of a conductive polymer and the first electrically conductive layer.

In a further embodiment, the flexible conductive composite foil comprises a laminate of a support material layer foil and an electrically conductive layer foil (as first electrically conductive layer). For instance, the laminate may comprise a laminate of an iron foil or an iron alloy foil, and a titanium foil. Such foils may be obtained by laminating (like rolling) the foils to each other. Again, the support material layer foil may be selected from the group consisting of iron foil, iron alloy foils, steel foils (including for instance foils of carbon steel, stainless steel, HSLA steel (high strength low alloy), or tool steel), aluminium foil, copper alloy foils, brass (CuZn) foils, resistance foils (CuNi), nickel foils, silver foils, nickel silver foils, iron nickel foils (such as invar), and the electrically conductive layer foil (as first electrically conductive layer) may comprise a foil selected from the group consisting of a titanium foil, a tin foil and a zinc foil.

In this embodiment (not forming part of of the invention), the layer thickness of the first electrically conductive layer foil may for instance be in the range of about 5-200 µm, especially 10-100 µm. Hence, the layer thickness of the first electrically conductive layer foil and the oxide layer together may also be in the range of about 5-200 µm, especially 10-100 µm.

Referring to the support material layer foil as described above in a number of embodiments, especially preferred support material layer foils are those comprising iron or iron alloys, such as steel foils (including for instance foils of carbon steel, stainless steel, HSLA steel (high strength low alloy), or tool steel), and iron nickel foils (such as invar). The support material layer foil is in contact with the first electrically conductive layer.

With the use of zinc, tin or titanium a skin of zinc oxide, tin oxide, respectively titanium oxide may result when the semiconductor layer deposited thereon is sintered, which "skin" on the one hand may provide a protection for the underlying zinc, tin, respectively titanium, and on the other hand may provide a good electrical conductor owing to its photoelectric properties. Oxide skins of the metal of the first electrically conductive layer are herein also indicated as "native oxides" or "native oxide skins".

Alternatively (or optionally also additionally), a non-native oxide ("skin") may be provided. For instance, a zinc oxide layer may be provided to a first electrically conductive layer comprising titanium, or a titanium oxide layer may be provided to a first electrically conductive layer comprising zinc, etc. Such non-native oxide layer may for instance be provided by providing a multi-layer comprising a titanium layer (attached to the support material layer foil) and a zinc layer (oxide precursor layer) or alternatively a zinc layer (attached to the support material layer foil) and a titanium layer (oxide precursor layer), wherein (at least part of) the latter layers (i.e. the zinc and titanium oxide precursor layer, respectively) are oxidized to form an oxide, during sintering the semiconductor layer to this oxide precursor layer. Such non-native oxide may for instance be provided by deposition, which may in embodiments be electrochemical deposition, may be spray pyrolysis or chemical vapour deposition (optionally followed by calcination to provide the oxide skin).

Hence, the oxide layer may be selected from the group consisting of a native-oxide layer or a non-native oxide layer, and may comprise one or more oxides selected from the group consisting of titanium oxide, tin oxide and zinc oxide.

Herein, instead of zinc or titanium, also a titanium zinc alloy may be applied; i.e., the first electrically conductive layer and/or the oxide layer may comprise an alloy or mixed oxide, respectively. Hence, the native oxide or the non-native oxide layer may also be a mixed oxide (i.e. mixed titanium oxide zinc oxide).

Therefore, the first electrically conductive layer may comprise one or more metals selected from the group consisting of titanium, zinc and tin. Hence, the phrase "a layer selected from the group consisting of a titanium layer, a tin layer and a zinc layer" in an embodiment also refers to a layer comprising one or more metals selected from the group consisting of titanium, zinc and tin. Titanium or titanium alloys, and especially titanium, are preferred as first electrically conductive layer.

Likewise, the oxide layer may comprise one or more oxides selected from the group consisting of titanium, zinc and tin. The oxide layer may comprise one or more native metal oxides, as a result of oxidation of the top layer of the first electrically conductive layer (i.e. native oxides or native oxide layer).

In a further aspect (not forming part of the invention) there is provided a photovoltaic element (or solar cell), comprising a layered structure, wherein the layered structure comprises:
a. flexible conductive composite foil, including
   i. a support material layer foil and
   ii. a first electrically conductive layer, wherein the first electrically conductive layer is a conductive oxide layer; the first electrically conductive layer in contact with
b. a crystalline metal-oxide semi-conductor layer; the crystalline metal-oxide semi-conductor layer in contact with
c. a photosensitization material; the photosensitization material in contact with
d. a hole conducting medium; the hole conducting medium in contact with
e. a catalyst layer ; the catalyst layer in contact with
f. a transparent second electrically conductive layer; and the transparent second electrically conductive layer in contact with
g. a transparent substrate (especially a flexible transparent substrate).

Preferably, the first electrically conductive layer is a layer obtained by providing a metallic layer and oxidizing said metallic layer to provide the conductive oxide layer. The layer may be oxidized entirely or partly. In a specific embodiment, the metallic layer is selected from the group consisting of a titanium layer, a tin layer and a zinc layer. In this way, the conductive oxide layer is selected from the group consisting of titanium oxide, tin oxide and zinc oxide, respectively.

An advantage of this embodiment may be the relative ease with which such PV may be produced. For instance, on known support material foils (see below), the metal oxide layer may be arranged, with techniques known in the art (see also below).

Here, the flexible conductive composite foil may comprise a laminate comprising a support material layer foil and the first electrically conductive layer. Herein, a support material layer in the form of a foil is indicated as "support material layer foil".

In general, the support material layer foil may be selected from the group consisting of iron foil, iron alloy foils, steel foils (including for instance foils of carbon steel, stainless steel, HSLA steel (high strength low alloy), or tool steel), aluminium foil, copper alloy foils, brass (CuZn) foils, resistance foils (CuNi), nickel foils, silver foils, nickel silver foils, iron nickel foils (such as invar), and the first electrically conductive layer may comprise a layer selected from the group consisting of a titanium oxide layer, a tin oxide layer and a zinc oxide layer, or of mixed oxides of two or more of these oxides.

In an embodiment, the support material layer foil comprises an iron foil or an iron alloy foil and the first electrically conductive layer comprises a titanium oxide layer. In another embodiment, the support material layer foil comprises an iron foil or an iron alloy foil, and the first electrically conductive layer comprises a tin oxide layer. In another embodiment, the support material layer foil comprises an iron foil or an iron alloy foil, and the first electrically conductive layer comprises a zinc oxide layer. Especially, the foil comprises an iron alloy foil, such as a steel foil. In another embodiment, the support material layer foil comprises an aluminium foil and the first electrically conductive layer comprises a titanium oxide layer. In another embodiment, the support material layer foil comprises an aluminium foil and the first electrically conductive layer comprises a zinc oxide layer. In yet another embodiment, the support material layer foil comprises an aluminium foil and the first electrically conductive layer comprises a tin oxide layer.

Such laminate comprising a support material layer foil and the first electrically conductive layer may for instance be obtained by providing a support material layer foil and providing by deposition thereon the first electrically conductive layer. Deposition may in an embodiment be electrochemical deposition, may be spray pyrolysis or chemical vapour deposition (optionally followed by calcination to provide the oxide skin). In another embodiment, deposition may comprise sputtering. Other techniques known in the art may also be applied. An advantage of the laminate comprising a support material layer foil and the first electrically conductive layer (wherein the first electrically conductive layer is the conductive oxide layer) is that the first electrically conductive layer may be very thin, such as in the range of about one atomic layer (about 0.1 nm) up to about 100 nm, and that such embodiment may be relatively easily produced. However, the layer thickness of the first electrically conductive (oxide) layer may also be up to about a 1 µm. Especially, the first electrically conductive (oxide) layer may have a layer thickness in the range of about 20-100 nm. However, the layer thickness of the first electrically conductive (oxide) layer may also be up to about 2 µm.

The semiconductor material in a photovoltaic element according to the invention is for instance zinc oxide, tin oxide or, preferably, titanium dioxide. In an embodiment, combinations of two or more of these oxides can also be applied as semiconductor material.

The layer of semiconductor material preferably comprises a layer of photo-sensitization material deposited thereon, in particular a photo-sensitive dye, which is selected from suitable dyes known per se in the field.

The semiconductor material is a porous material, wherein within the pores, deposited on the semiconductor material photosensitization material is deposited. Thereon, an electrolytic liquid (or other hole conducting medium) is provided, also indicated as electrolyte.

Herein, the term "electrolyte" is used. This term is known to the person skilled in the art. Preferred electrolytes are based on iodine (i.e. iodide/iodine). Instead of an electrolyte, also other hole conducting media may be applied, such as for instance hole conducting polymers, such P3HT (poly(3-hexylthiophene)), or organic hole conducting materials, such as spiro-O-Me TAD. Therefore, in an embodiment, the term "electrolytic liquid" may be broader interpreted as "hole conducting medium", and thus the photosensitization material is in contact with a hole conducting medium, such as an electrolytic liquid, like an iodide/iodine based electrolyte, and the hole conducting medium is in contact with the catalyst layer.

The catalyst layer may comprise one or more catalysts selected from the group consisting of carbon, platinum and palladium, especially platinum and/or palladium, but may in an other embodiment also comprise a catalytically active conducting polymer, such as especially poly(dioctyl-bithiophene) (also known in the art as "PEDOT").

The transparent substrate in a photovoltaic element according to the invention especially comprises a foil of flexible plastic material (also indicated as transparent polymer foil), preferably polyethylene terephthalate (PET) or polyethylene naphtalate (PEN), especially PEN, because of its relative advantageous thermal properties.

### Brief description of the drawings

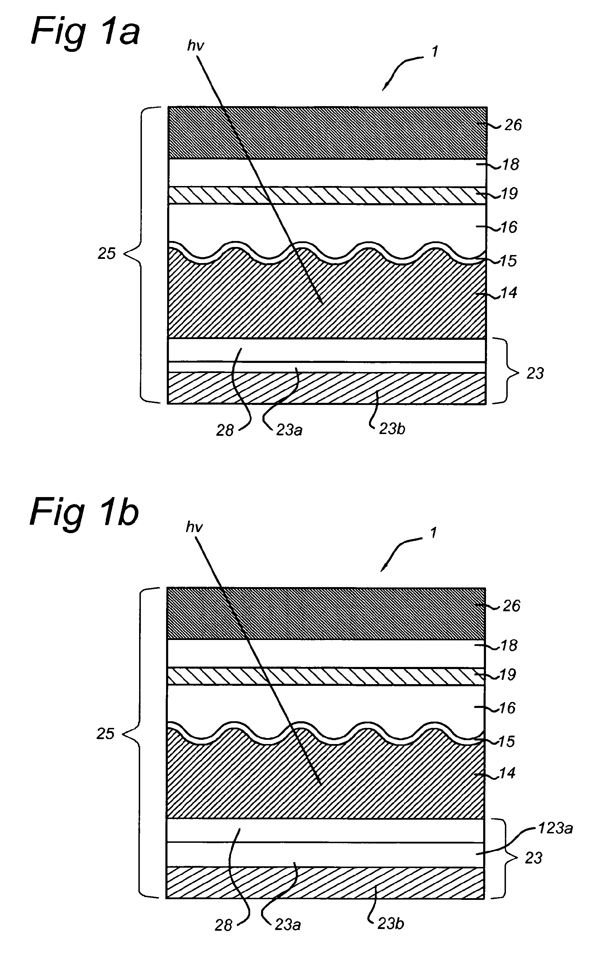

Embodiments of the invention will now be described, by way of example only, with reference to the accompanying schematic drawings in which corresponding reference symbols indicate corresponding parts, and in which Figures1a-1c show in schematic cross-section non-limiting embodiments of a solar cell according to the invention. These figures are not on scale.

### Description of preferred embodiments

Figures 1a and 1b schematically show a stack or layered structure 25 of a solar cell 1, which is substantially built up of a flexible conductive composite foil 23, a porous layer of nanocrystalline titanium dioxide 14 (or another semi conductor), a layer 15 of a suitable dye-sensitizer, a (lithium) iodide/iodine solution 16 (or another hole conducting medium such as an iodide/iodine based electrolyte) and a transparent substrate 26, especially a flexible foil 26, for instance PEN, on which a layer 18 of a transparent conductive oxide (TCO) (such as indium tin oxide) is deposited. Layer 15 is shown in greatly simplified manner. In reality the dye sensitizer is applied in a solution to semiconductor layer 14 and penetrates into the pores thereof, so that the dye covers the whole semiconductor surface. The flexible conductive composite foil 23 comprises a laminate of a support material layer foil 23b and a first electrically conductive layer 23a, which may in an embodiment also be a foil (fig. 1a).

The layer of titanium dioxide 14 may be formed in accordance with a per se known method by sintering a dispersion of colloidal particles of titanium dioxide onto flexible conductive composite foil 23, wherein between the sintered titanium dioxide 14 and composite foil 23 a layer of oxide 28, such as titanium dioxide, is present, which protects the underlying first electrically conductive layer 23a against the corrosive action of the hole conducting medium (such as lithium iodide/iodine) 16.

The figure further shows a layer 19 (not shown to scale) of a catalyst, for instance carbon, for the conversion of neutral I in the lithium iodide solution to iodine by accepting an electron from counter-electrode 18. In this solar cell 1 light (indicated by arrows designated hv, wherein h represents Planck's constant and v the frequency of the incident light) is incident on dye layer 15 via counter-electrode or second electrically conductive layer 18 and the lithium iodide/iodine solution as hole conducting medium 16. Another catalyst may for instance be platinum or optionally palladium. In a preferred embodiment, Pt is applied as catalyst.

Figure 1a especially schematically shows an embodiment wherein the first electrically conductive layer essentially consists of first electrically conductive layer 23a, whereas figure 1b schematically shows an embodiment wherein the first electrically conductive layer essentially consists of first electrically conductive layer foil 123a.

Hence, the invention provides solar cell or photovoltaic element 1, which is a layered structure or stack 25, comprising the flexible conductive composite foil 23, including support material layer foil 23b and first electrically conductive layer 23a, the oxide layer 28, the crystalline metal-oxide semi-conductor layer 14, the photosensitization material 15, electrolytic liquid (or other hole conducting medium) 16, catalyst layer 19, transparent second electrically conductive layer 18 and transparent flexible substrate 26.

The invention further provides a photovoltaic element 1 comprising a layered structure 25 of at least a first electrically conductive layer 23a, a layer of crystalline metal oxide semiconductor material 14 deposited on the first electrically conductive layer 23a, a layer of photosensitization material 15 deposited on the semiconductor material 14 a transparent second electrically conductive layer 18 deposited on a transparent substrate 26, and a hole conducting medium (such as an electrolytic liquid) 16 contained between the layer of semiconductor material 14 and the second electrically conductive layer 18, wherein the photovoltaic element is flexible, the layer of semiconductor material 14 is deposited on a flexible conductive composite foil 23, which flexible conductive composite foil 23 comprises the first electrically conductive layer 23a and a support material layer foil 23b, and the transparent substrate 26 is a foil of flexible plastic material.

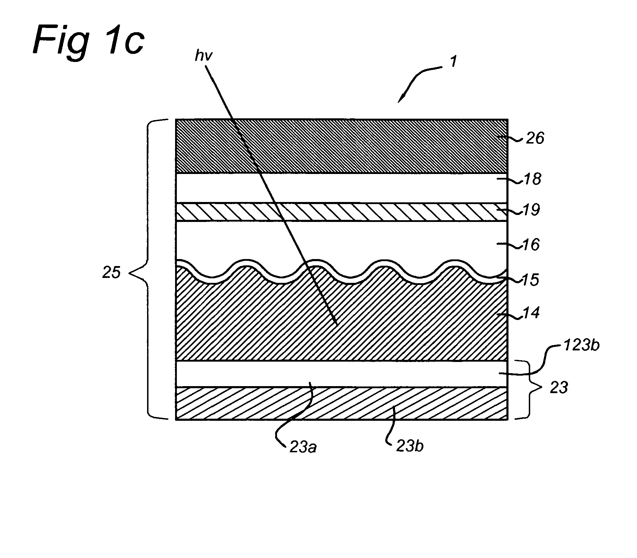

In a specific embodiment (not forming part of the invention), the first electrically conductive layer 23a comprises a conductive oxide layer (see also above). Such embodiment is schematically depicted in figure 1c, in contrast to the above described embodiments, substantially no metallic tin, titanium or zinc is present (as layer), but substantially, only oxides of one or more of those metals are present. Hence, the conductive oxide layer 23a and the (native) oxide layer 28 are in this embodiment one and the same layer, also indicated with reference 123b, which refers to the first electrically conductive layer 23a, wherein this layer is an oxide layer, especially selected of one or more oxides of the group tin oxide, titanium oxide and zinc oxide. For instance, the support material layer foil 23b may be an iron or iron alloy foil, wherein with organo metal compounds with Ti, Sn or Zn as metal, the respective oxides are deposited by spray pyrolysis, thereby providing flexible conductive composite foil 23.

It is noted that the examples given here serve to elucidate the invention, not to limit the scope thereof. A "reversed" dye-sensitized solar cell according to the invention can for instance also contain, instead of the above mentioned lithium iodide, another per se known suitable electrolytes such as potassium bromide/bromine or potassium iodide/iodine, or other hole conducting mediums known in the art.

Referring to figures 1a-1c, the crystalline metal-oxide semiconductor layer is especially obtainable by sintering a dispersion of colloidal particles of titanium dioxide onto flexible conductive composite foil 23. In this way, nano porous metal oxide, like nano porous titanium dioxide may be obtained, as known in the art.

The term "substantially" herein, such as in "substantially all emission" or in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements.

The mere fact that certain measures are recited in mutually different dependent claims does not indicate that a combination of these measures cannot be used to advantage.

## Claims

1. A photovoltaic element (1), comprising a layered structure (25), wherein the layered structure (25) comprises:
a. flexible conductive composite foil (23), including
a first electrically conductive layer (23a) comprising a layer selected from the group consisting of a titanium layer, a tin layer and a zinc layer; the first electrically conductive layer (23a) in contact with
b. an oxide layer (28); the oxide layer (28) in contact with
c. a crystalline metal-oxide semi-conductor layer (14); the crystalline metal-oxide semi-conductor layer (14) in contact with
d. a photosensitization material (15), wherein the photo-sensitization material is a photo-sensitive dye; the photosensitization material (15) in contact with
e. a hole conducting medium (16); the hole conducting medium (16) in contact with
f. a catalyst layer (19); the catalyst layer (19) in contact with
g. a transparent second electrically conductive layer (18); and the transparent second electrically conductive layer (18) in contact with
h. a flexible transparent substrate (26), **characterized in that** the flexible composite foil (23) further comprises a support material layer foil (23b) and
wherein the first electrically conductive layer (23a) and the oxide layer (28) together have a layer thickness in the range of 20 nm - 2 µm.

2. The photovoltaic element (1) according to any one of the preceding claims, wherein the first electrically conductive layer (23a) comprises a titanium layer.

3. The photovoltaic element (1) according to any one of claims 1 - 2, wherein the first electrically conductive layer (23a) and the oxide layer (28) together have a layer thickness in the range of 20-100 nm.

4. The photovoltaic element (1) according to any one of the preceding claims, wherein the support material layer foil (23b) is selected from the group consisting of iron foil, iron alloy foil, steel foil, aluminium foil, copper alloy foil, brass (CuZn) foil, resistance foils (CuNi), nickel foils, silver foils, nickel silver foils, and iron nickel foils.

5. The photovoltaic element (1) according to any one of the preceding claims, wherein the support material layer foil (23b) is selected from the group consisting of iron foil and iron alloy foil.

6. The photovoltaic element (1) according to any one of the preceding claims, wherein the transparent substrate (26) is polyethylene terephthalate (PET) or polyethylene naphtalate (PEN).

7. The photovoltaic element (1) according to any one of the preceding claims, wherein the transparent substrate (26) is polyethylene naphtalate (PEN).

## Patentansprüche

1. Fotovoltaikelement (1), das eine geschichtete Struktur (25) umfasst, wobei die geschichtete Struktur (25) umfasst:
a. eine flexible leitfähige Verbundfolie (23), die eine erste elektrisch leitfähige Schicht (23a) enthält, die eine Schicht umfasst, die aus der Gruppe ausgewählt ist, die aus einer Titanschicht, einer Zinnschicht und einer Zinkschicht besteht; wobei die erste elektrisch leitfähige Schicht (23a) in Kontakt steht mit
b. einer Oxidschicht (28); wobei die Oxidschicht (28) in Kontakt steht mit
c. einer kristallinen Metalloxid-Halbleiterschicht (14); wobei die kristalline Metalloxid-Halbleiterschicht (14) in Kontakt steht mit
d. einem Fotosensibilisatormaterial (15), wobei das Fotosensibilisatormaterial (15) eine lichtempfindliche Tinte ist; wobei das Fotosensibilisatormaterial (15) in Kontakt steht mit
e. einem Löcherleitmedium (16); wobei das Löcherleitmedium (16) in Kontakt steht mit
f. einer Katalysatorschicht (19), wobei die Katalysatorschicht (19) in Kontakt steht mit
g. einer transparenten zweiten elektrisch leitfähigen Schicht (18); wobei die transparente zweite elektrisch leitfähige Schicht (18) in Kontakt steht mit
h. einem flexiblen transparenten Substrat (26)
**dadurch gekennzeichnet, dass** die flexible leitfähige Verbundfolie (23) darüber hinaus eine Trägermaterialschichtfolie (23b) umfasst, und
wobei die erste elektrisch leitfähige Schicht (23a) und die Oxidschicht (28) zusammen eine Schichtdicke im Bereich von 20 nm - 2µm aufweisen.

2. Fotovoltaikelement (1) nach einem der vorhergehenden Ansprüche, wobei die erste elektrisch leitfähige Schicht (23a) eine Titanschicht umfasst.

3. Fotovoltaikelement (1) nach einem der Ansprüche 1 - 2, wobei die erste elektrisch leitfähige Schicht (23a) und die Oxidschicht (28) zusammen eine Schichtdicke im Bereich von 20 - 100 nm aufweisen.

4. Fotovoltaikelement (1) nach einem der vorhergehenden Ansprüche, wobei die Trägermaterialschichtfolie (23b) aus der Gruppe ausgewählt ist, die aus Eisenfolie, Eisenlegierungsfolie, Stahlfolie, Aluminiumfolie, Kupferlegierungsfolie, Messingfolie (CuZn-Folie), Widerstandsfolien (CuNi), Nickelfolien, Silberfolien, Nickel-Silber-Folien und Eisen-Nickel-Folien besteht.

5. Fotovoltaikelement (1) nach einem der vorhergehenden Ansprüche, wobei die Trägermaterialschichtfolie (23b) aus der Gruppe ausgewählt ist, die aus Eisenfolie und Eisenlegierungsfolie besteht.

6. Fotovoltaikelement (1) nach einem der vorhergehenden Ansprüche, wobei das transparente Substrat (26) Polyethylenterephthalat (PET) oder Polyethylennaphthalat (PEN) ist.

7. Fotovoltaikelement (1) nach einem der vorhergehenden Ansprüche, wobei das transparente Substrat (26) Polyethylennaphthalat (PEN) ist.

## Revendications

1. Elément photovoltaïque (1), comprenant une structure stratifiée (25), dans lequel la structure stratifiée (25) comprend:
a) une feuille composite conductrice flexible (23), incluant une première couche électriquement conductrice (23a) comprenant une couche choisie dans le groupe consistant en couche de titane, couche d'étain et couche de zinc ; la première couche électriquement conductrice (23a) étant en contact avec
b) une couche d'oxyde (28) ; cette couche d'oxyde (28) étant en contact avec
c) une couche semi-conductrice de métal-oxyde cristalline (14) ; cette couche semi-conductrice de métal-oxyde cristalline (14) étant en contact avec
d) un matériau photosensibilisateur (15), dans lequel le matériau photosensibilisateur est un colorant photosensible ; le matériau photosensibilisateur (15) étant en contact avec
e) un milieu conducteur par trous (16) ; ce milieu conducteur par trous (16) étant en contact avec
f) une couche de catalyseur (19) ; cette couche de catalyseur (19) étant en contact avec
g) une seconde couche électriquement conductrice transparente (18) ; la seconde couche électriquement conductrice transparente (18) étant en contact avec
h) un substrat transparent flexible (26),
cet élément photovoltaïque étant **caractérisé en ce que** la feuille composite conductrice flexible (23) comprend en outre une feuille de couche de matériau de support (23b) et **en ce que** la première couche électriquement conductrice (23a) et la couche d'oxyde (28) présentent ensemble une épaisseur de couche dans la plage de 20 nm à 2 µm.

2. L'élément photovoltaïque (1) selon la revendication précédente, dans lequel la première couche électriquement conductrice (23a) comprend une couche de titane.

3. L'élément photovoltaïque (1) selon l'une quelconque des revendications 1 à 2, dans lequel la première couche électriquement conductrice (23a) et la couche d'oxyde (28) ont ensemble une épaisseur de couche dans la plage de 20 à 100 nm.

4. L'élément photovoltaïque (1) selon l'une quelconque des revendications précédentes, dans lequel la feuille de couche de matériau de support (23b) est choisie dans le groupe constitué d'une feuille de fer, feuille d'alliage de fer, une feuille d'acier, une feuille d'aluminium, une feuille d'alliage de cuivre, une feuille de laiton (CuZn), des feuilles de résistance (CuNi), des feuilles de nickel, des feuilles d'argent, des feuilles argent-nickel, des feuilles nickel-fer.

5. L'élément photovoltaïque (1) selon l'une quelconque des revendications précédentes, dans lequel la feuille de couche de matériau de support (23b) est choisie dans le groupe des feuilles de fer et des feuilles d'alliages de fer.

6. L'élément photovoltaïque (1) selon l'une quelconque des revendications précédentes, dans lequel le substrat transparent (26) est en polyéthylène téréphtalate (PET) ou en polyéthylène naphtalate (PEN).

7. L'élément photovoltaïque (1) selon l'une quelconque des revendications précédentes, dans lequel le substrat transparent (26) est en polyéthylène naphtalate (PEN).
